# FASCICULE DE BREVET EUROPEEN

(11) **EP 3 697 189 B1**
(45) Date de publication et mention de la délivrance du brevet: **05.04.2023**
(21) Numéro de dépôt: 20157062.9
(22) Date de dépôt: 13.02.2020
(51) Int. Cl.: H05K 13/04

(54) **PROCÉDÉ DE PRÉHENSION DE COMPOSANTS ÉLECTRONIQUES MAGNÉTIQUES AVEC UN AIMANT**
GREIFVERFAHREN VON MAGNETISCHEN ELEKTRONISCHEN KOMPONENTEN MIT EINEM MAGNETEN
METHOD FOR GRIPPING MAGNETIC ELECTRONIC COMPONENTS WITH A MAGNET

(30) Priorité: 14.02.2019 FR 1901489
(43) Date de publication de la demande: 19.08.2020
(73) Titulaire: MGA Technologies, 69380 Civrieux d'Azergues (FR)
(72) Inventeur: de MALLIARD, Hervé, 69160 Tassin la Demi-Lune (FR)
(74) Mandataire: Cabinet Laurent & Charras

(56) Documents cités:
- WO-A1-2018/101169
- US-A- 3 231 968
- US-A1- 2005 035 613
- US-A1- 2018 301 265

## Description

La présente invention concerne un procédé de préhension de composants magnétiques, ainsi qu'un système de préhension mettant en oeuvre un tel procédé.

Parmi ces composants, on trouve notamment des composants électroniques qui possèdent un corps magnétique équipé de broches pour assurer des contacts électriques. En particulier les véhicules automobiles comportent un nombre croissant de systèmes électroniques comprenant de tels composants, notamment pour améliorer le contrôle de la combustion des moteurs thermiques ou pour intégrer des machines électriques de traction pour les véhicules hybrides, afin de réduire la consommation d'énergie et les émissions de gaz polluants, pour aider à la conduite, pour l'automatiser, ou pour de nombreuses autres fonctions afin d'améliorer le confort et la sécurité.

En particulier les capteurs à effet hall sont de plus en plus utilisés dans des systèmes mécatroniques, pour mesurer ou contrôler des déplacements ou des positions.

Ces composants peuvent, lors de leur fabrication, être positionnés et placés avec un pas constant sur une bande support continue, qui est enroulée sous forme de bobine. Les machines utilisant ces composants déroulent en amont la bobine, et placent chaque composant les uns après les autres à un emplacement de préhension, où il est extrait de sa bande pour être disposé à un poste de travail suivant.

Toutefois le positionnement des différents composants sur la bande par rapport à sa position théorique peut être variable, avec des écarts de plusieurs dixièmes de millimètres d'un composant à l'autre ce qui pose des difficultés de préhensions répétitives et fiables avec des cadences élevées, sans appliquer de contraintes mécaniques trop élevées sur ces composants. Des contraintes trop importantes entraîneraient des rebuts détectés avant ou après le montage sur des ensembles, ce qui augmente les coûts.

Les procédés connus, et les différents systèmes de préhension mettant en oeuvre ces procédés, répondent mal à ces problèmes. La présente invention a notamment pour but d'éviter ces inconvénients de la technique antérieure. WO2018101169 et US2018301265 montrent des machines prenant des composants électroniques par moyens magnétiques.

Elle propose à cet effet un procédé de préhension d'au moins un composant comprenant au moins une partie de corps magnétique, remarquable en ce qu'il comporte successivement une étape de descente sensiblement verticale d'une forme de positionnement inférieure d'une tête de préhension, s'ajustant sur la partie de corps magnétique du composant, puis de changement d'état d'un actionneur qui descend un plot présentant une base magnétique venant sur la forme de positionnement en adhérant sur la partie de corps magnétique du composant, puis de remontée et de déplacement de la tête de préhension.

Un avantage de ce procédé est que l'application de la base magnétique du plot sur le composant lors de la descente de l'actionneur garantit l'adhérence de ce composant sous l'électroaimant, même avec une dispersion importante de positionnement du composant sur son support, ce qui assure sa préhension correcte à chaque opération.

On obtient ainsi un procédé d'alimentation de postes de travail fiable avec une cadence pouvant être élevée. De plus l'adhérence de l'aimant sur le dessus du composant se faisant indépendamment des formes variées qu'il peut présenter, on peut réaliser une tête de préhension standard s'adaptant à une variété de formes de composant.

Le procédé de préhension selon l'invention, ainsi qu'un système de mettant en oeuvre ce procédé, peuvent comporter de plus une ou plusieurs des caractéristiques suivantes, qui peuvent être combinées entre elles. Avantageusement, le procédé comporte une étape préliminaire de détection du composant à son emplacement de préhension avec une tête de lecture laser. Avantageusement, le procédé comporte une étape finale de descente de la tête de préhension et de dépose du composant sur un posage horizontal.

Dans ce cas, avantageusement le procédé effectue la dépose du composant sur le posage avec un jeu latéral par rapport à un rebord de ce posage.

De plus, avantageusement après la dépose du composant sur le posage, le procédé applique un mouvement latéral de ce composant pour le mettre en quasi contact avec le rebord latéral du posage formant une référence de position. la mise en référence définitive pourra se réaliser naturellement du fait de l'attraction magnétique entre le composant et le posage.

Avantageusement, le procédé active un électroaimant formant l'actionneur, pour faire monter ou descendre le plot.

L'invention a aussi pour objet un système de préhension de composants magnétiques, remarquable en ce qu'il comporte au moins une tête de préhension se déplaçant, mettant en oeuvre un procédé de préhension comprenant l'une quelconque des caractéristiques précédentes.

En particulier, la tête de préhension peut se déplacer suivant un axe horizontal et un axe vertical.

En particulier, le système de préhension peut comporter un plateau tournant comprenant des posages répartis autour de ce plateau, recevant successivement les composants.

Selon un mode de réalisation, le système de préhension comporte un dispositif d'alimentation des composants qui sont posés sur une bande continue.

L'invention sera mieux comprise et d'autres caractéristiques et avantages apparaîtront plus clairement à la lecture de la description ci-après donnée à titre d'exemple, en référence aux dessins annexés dans lesquels :
[Fig.1] présente la partie préhension d'une machine mettant en oeuvre un procédé de préhension selon l'invention ;
[Fig.2] présente la descente de la tête de préhension sur le composant, vue en perspective ;
[Fig.3] présente la descente de la tête de préhension sur le composant, vue de face ;
[Fig.4] présente la désactivation d'un électroaimant de cette tête formant un actionneur qui descend son noyau, et l'adhérence du composant dessous ;
[Fig.5] présente la montée de cette tête avec le composant ;
[Fig.6] présente le déplacement latéral de cette tête ;
[Fig.7] présente la descente de la tête sur un plateau tournant de réalisation des opérations de coupe et cambrage, vue en perspective ;
[Fig.8] présente la descente de la tête sur un plateau tournant de réalisation des opérations de coupe et cambrage, vue de côté ;
[Fig.9] présente le calage latéral du composant, vu en perspective ;
[Fig.10] présente le calage latéral du composant, vu de côté ;
[Fig.11] présente l'activation de l'électroaimant qui remonte son noyau ; et
[Fig.12] présente la remontée et la translation de la tête.

D'une manière générale le procédé de préhension selon l'invention peut s'appliquer à tous types de composants électriques ou non, comprenant un corps présentant au moins une partie de corps magnétique, délivrés sur différents supports, en particulier sur une bande continue.

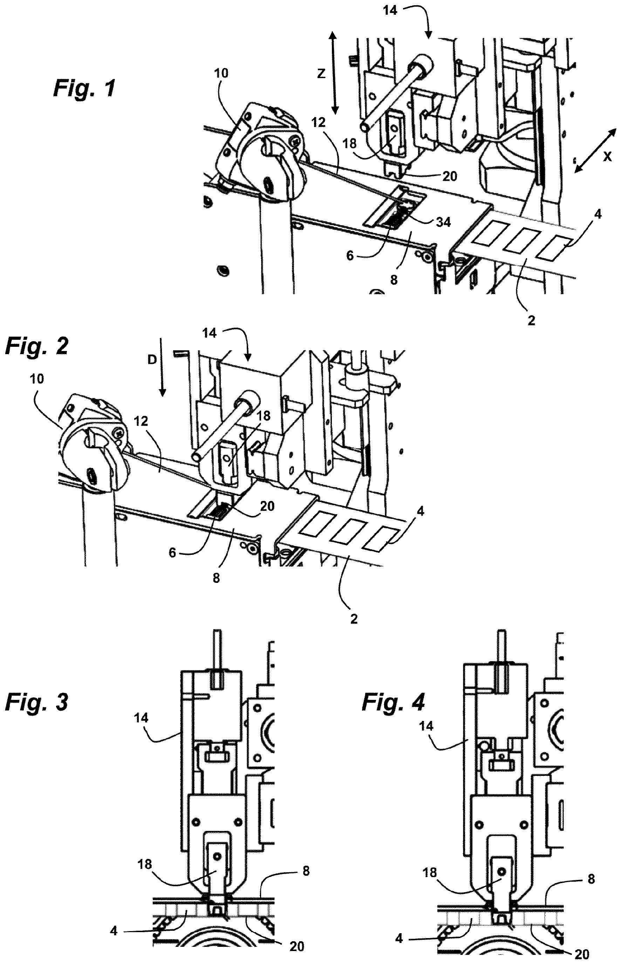

La figure 1 présente une machine de coupe et cambrage des broches 34 de composants électroniques 6, gérée entièrement par des commandes numériques programmées effectuant les différents contrôles des mouvements, qui s'adapte à différents types de composants comprenant des corps variés et devant subir des formages particuliers de leurs broches.

Une bande 2 assurant l'alimentation des composants électroniques magnétiques 6, présente une succession d'alvéoles 4 disposées suivant un pas constant, contenant chacune un composant disposant de broches de liaison électrique. Dans cet exemple chaque composant 6 présente trois broches parallèles 34 disposées horizontalement, perpendiculairement à la direction de la bande 2. La bande venant d'une bobine qui se déroule, coulisse dans un guidage comprenant une tôle supérieure 8 disposant d'une fenêtre, de manière à disposer successivement chaque composant devant cette fenêtre. Une tête de lecture laser 10 fixée sur un support, dirige un rayon laser 12 sur le composant 6 disposé dans la fenêtre, pour vérifier sa présence.

Une tête de préhension 14 de la machine, alignée verticalement au-dessus du composant 6 à saisir, comporte des guidages linéaires motorisés réalisant un mouvement vertical de la tête suivant l'axe Z, et un mouvement horizontal de cette tête suivant l'axe X.

La tête de préhension 14 comporte à sa base une forme de positionnement inférieur 20 réalisée en matériau non magnétique, constituant un creux ouvert vers le bas, entouré de rebords disposant de pentes formant des chanfreins d'entrée qui s'ajustent autour du corps du composant 6 lors de sa descente. Après sa descente la forme de positionnement 20 entoure le corps du composant 6 en le repositionnant latéralement si nécessaire, les broches 34 sortant par une ouverture latérale de cette forme.

La tête de préhension 14 comporte un électroaimant comprenant un noyau coulissant verticalement, lié à un plot 18 présentant une base magnétique, aimantée ou pas, qui descend quand cet électroaimant est désactivé par un courant électrique, en ajustant cette base sur le dessus du corps du composant 6. Le noyau descend sous l'effet d'un ressort de descente quand l'électroaimant est désactivé.

Les figures 2 et 3 présentent après la détection du composant 6 par la tête de lecture laser 10, la descente D de la tête de préhension 14, le plot 18 reste à une distance définie au-dessus du corps du composant 6, suffisante pour empêcher que ce corps ne se soulève par magnétisme lors de l'approche de la tête de préhension.

La figure 4 présente la désactivation de l'électroaimant qui a pour effet de descendre le plot 18 sous l'effet du ressort, en ajustant sa base aimantée sur le composant 6, sans appliquer d'effort dessus. De cette manière on fixe le composant 6 sous la tête de préhension 14 sans risquer de l'endommager. En effet, il reste un léger jeu entre la face magnétique du plot 18 et le composant 6, afin d'éviter d'abîmer la partie active de la cellule qui est en silicium. Ainsi, le composant adhère par magnétisme, tout en se mettant bien en appui sur la forme de positionnement 20 pour être positionné.

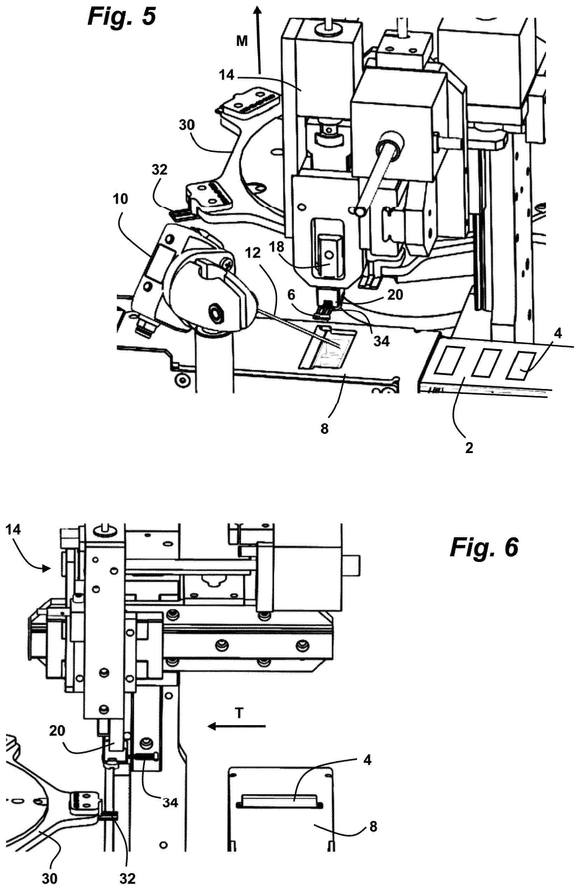

La figure 5 présente la montée M de la tête de préhension 14, qui emporte en même temps le composant 6 aimanté au plot 18.

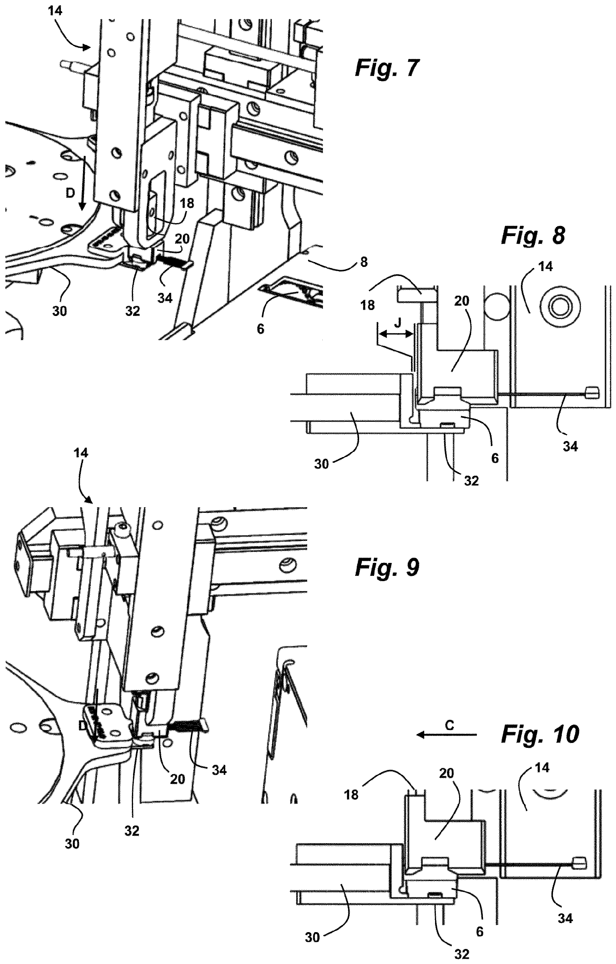

La figure 6 présente la translation horizontale T suivant l'axe X de la tête de préhension 14, qui vient aligner verticalement le composant 6 au-dessus d'un posage 32 fixé sur le contour d'un plateau 30 tournant suivant un axe central vertical, comprenant plusieurs posages répartis régulièrement sur son pourtour. Les figures 7 et 8 présentent la descente D de la tête de préhension 14, le composant 6 venant se poser sur le posage 32 avec ses broches 34 tournées radialement vers l'extérieur. Le posage 32 comporte un bossage vertical centré sur le composant 6, qui forme un rebord latéral 36 rentrant dans une découpe latérale de la forme de positionnement 20.

La pose du composant 6 se fait en prévoyant suivant la direction radiale du plateau 30, un jeu J entre le corps de ce composant et le rebord 36 formant un appui latéral de mise en référence.

De cette manière le composant 6 descend sur une partie plate horizontale du posage 32 qui est libre, sans risquer de buter lors de cette descente sur le rebord latéral 36 de ce posage qui pourrait appliquer sur ce composant des contraintes mécaniques en le détériorant.

Les figures 9 et 10 présentent un petit mouvement horizontal C de la tête de préhension 14 radialement vers le centre du plateau 30, qui vient mettre en contact le côté du composant 6 sur le rebord 36 formant un appui latéral du posage 32. De cette manière le composant 6 est indexé latéralement et en hauteur avec précision sur le plateau 30.

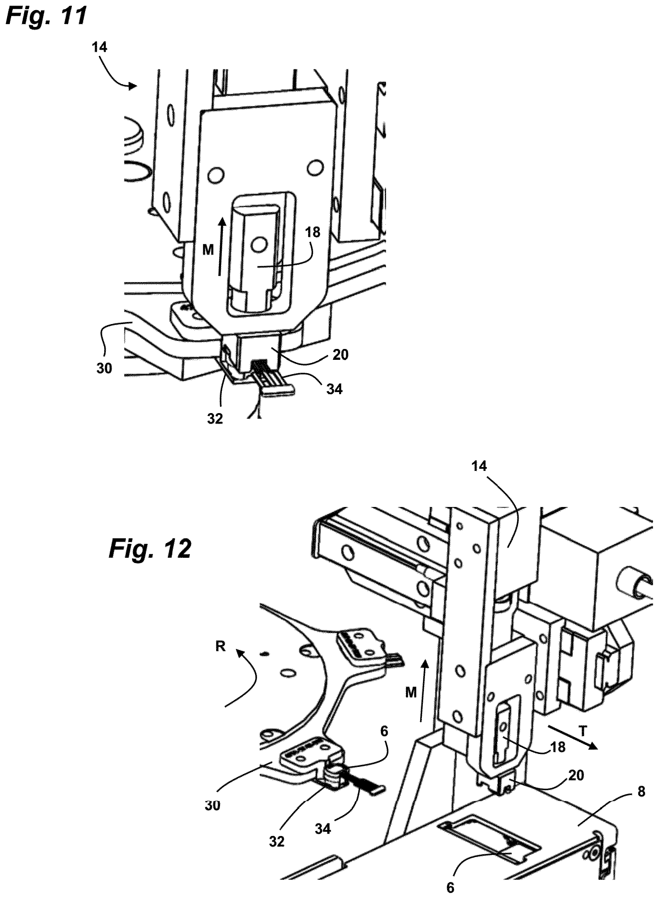

La figure 11 présente l'activation de l'électroaimant de la tête de préhension 14, qui entraîne la remontée du plot 18. Le plot 18 n'attire plus le composant 6, qui reste en position sur son posage 32.

La figure 12 présente enfin la montée M de la tête de préhension 14, puis sa translation T pour la repositionner au-dessus d'un nouveau composant 6 à prélever sur la bande 2.

Pendant ce temps le plateau 30 effectue une rotation R d'un pas pour présenter un nouveau support vide 32 au poste d'arrivée, et faire avancer chaque composant 6 sur les postes d'opérations successifs réalisant la coupe et le cambrage des broches 34.

Le dernier poste atteint par le composant 6 avant le poste d'arrivée, est un poste de départ comprenant une autre tête de préhension qui va prendre le composant préparé pour le conditionner.

En particulier grâce à des commandes numériques des différents mouvements, la machine mettant en oeuvre le procédé de préhension selon l'invention permet facilement des positionnements ajustables en hauteur de la tête de préhension 14 en fonction de l'épaisseur des composants 6 arrivant, indépendamment des contours variables de ces composants, ce qui lui donne une grande flexibilité pour s'adapter à différents composants. On peut utiliser le procédé de préhension pour tous composants en adaptant la forme de positionnement 20, et pour tout type d'opération sur ces composants.

## Revendications

1. Procédé de préhension d'au moins un composant (6) comprenant au moins une partie de corps magnétique, **caractérisé en ce qu'**il comporte successivement une étape de descente verticale d'une forme de positionnement inférieure (20) d'une tête de préhension (14), s'ajustant sur la partie de corps magnétique du composant (6), puis de changement d'état d'un actionneur qui descend un plot (18) présentant une base magnétique venant sur la forme de positionnement (20) en adhérant sur la partie de corps magnétique du composant (6), puis de remontée et de déplacement de la tête de préhension (14).

2. Procédé de préhension selon la revendication 1, **caractérisé en ce qu'**il comporte une étape préliminaire de détection du composant (6) à son emplacement de préhension avec une tête de lecture laser (10).

3. Procédé de préhension selon la revendication 1 ou 2, **caractérisé en ce qu'**il comporte une étape finale de descente de la tête de préhension (14) et de dépose du composant (6) sur un posage horizontal (32).

4. Procédé de préhension selon la revendication 3, **caractérisé en ce qu'**il effectue la dépose du composant (6) sur le posage (32) avec un jeu latéral (J) par rapport à un rebord de ce posage (32).

5. Procédé de préhension selon la revendication 4, **caractérisé en ce qu'**après la dépose du composant (6) sur le posage (32), il applique un mouvement latéral de ce composant (6) pour le mettre en contact avec le rebord latéral du posage (32) formant une référence de position.

6. Procédé de préhension selon l'une quelconque des revendications précédentes, **caractérisé en ce qu'**il active un électroaimant formant l'actionneur, pour faire monter ou descendre le plot (18).

7. Système de préhension de composants magnétiques (6), **caractérisé en ce qu'**il comporte au moins une tête de préhension (14) se déplaçant, mettant en oeuvre un procédé de préhension selon l'une quelconque des revendications précédentes.

8. Système de préhension selon la revendication 7, **caractérisé en ce que** la tête de préhension (14) se déplace suivant un axe horizontal (X) et un axe vertical (Z).

9. Système de préhension selon la revendication 7 ou 8, **caractérisé en ce qu'**il comporte un plateau tournant (30) comprenant des posages (32) répartis autour de ce plateau (30), recevant successivement les composants (6).

10. Système de préhension selon l'une quelconque des revendications 7 à 9, **caractérisé en ce qu'**il comporte un dispositif d'alimentation des composants qui sont posés sur une bande continue.

## Patentansprüche

1. Verfahren zum Greifen zumindest einer Komponente (6), die zumindest einen magnetischen Körperteil umfasst, **dadurch gekennzeichnet, dass** es nacheinander einen Schritt des vertikalen Absenkens einer unteren Positionierungsform (20) eines Greifkopfes (14) umfasst, der sich an den magnetischen Körperteil der Komponente (6) anpasst, dann des Änderns des Zustands eines Stellglieds, das ein Stück (18) absenkt, das eine magnetische Basis aufweist, die auf die Positionierungsform (20) kommt, indem es an dem magnetischen Körperteil der Komponente (6) anhaftet, dann des Anhebens und Bewegens des Greifkopfes (14).

2. Verfahren zum Greifen nach Anspruch 1, **dadurch gekennzeichnet, dass** es einen vorbereitenden Schritt des Erfassens der Komponente (6) an ihrer Greifstelle mit einem Laserlesekopf (10) umfasst.

3. Verfahren zum Greifen nach Anspruch 1 oder 2, **dadurch gekennzeichnet, dass** es einen Endschritt des Absenkens des Greifkopfes (14) und des Ablegens der Komponente (6) auf einer horizontalen Ablage (32) umfasst.

4. Verfahren zum Greifen nach Anspruch 3, **dadurch gekennzeichnet, dass** es die Ablage der Komponente (6) auf der Ablage (32) mit einem seitlichen Spiel (J) in Bezug auf einen Rand dieser Ablage (32) durchführt.

5. Verfahren zum Greifen nach Anspruch 4, **dadurch gekennzeichnet, dass** es nach dem Ablegen der Komponente (6) auf der Ablage (32) eine seitliche Bewegung dieser Komponente (6) anwendet, um sie mit dem seitlichen Rand der Ablage (32) in Kontakt zu bringen, der eine Positionsreferenz bildet.

6. Verfahren zum Greifen nach einem der vorstehenden Ansprüche, **dadurch gekennzeichnet, dass** es einen Elektromagneten aktiviert, der das Stellglied bildet, um das Stück (18) nach oben oder unten zu bewegen.

7. System zum Greifen für magnetische Komponenten (6), **dadurch gekennzeichnet, dass** es zumindest einen sich bewegenden Greifkopf (14) umfasst, das ein Verfahren zum Greifen nach einem der vorstehenden Ansprüche umsetzt.

8. System zum Greifen nach Anspruch 7, **dadurch gekennzeichnet, dass** sich der Greifkopf (14) entlang einer horizontalen Achse (X) und einer vertikalen Achse (Z) bewegt.

9. System zum Greifen nach Anspruch 7 oder 8, **dadurch gekennzeichnet, dass** es einen Drehtisch (30) umfasst, der um diesen Tisch (30) verteilte Ablagen (32) umfasst, die nacheinander die Komponenten (6) aufnehmen.

10. System zum Greifen nach einem der Ansprüche 7 bis 9, **dadurch gekennzeichnet, dass** es eine Vorrichtung zum Zuführen von Komponenten umfasst, die auf einem kontinuierlichen Band liegen.

## Claims

1. A method for gripping at least one component (6) comprising at least one magnetic body part, **characterised in that** it comprises successively a step of vertically lowering a lower positioning form (20) of a gripping head (14), that fits on the magnetic body part of the component (6), then changing the state of an actuator which lowers a stud (18) having a magnetic base coming onto the positioning form (20) by adhering to the magnetic body part of the component (6), then raising and moving the gripping head (14).

2. The gripping method according to claim 1, **characterised in that** it comprises a preliminary step of detecting the component (6) at its gripping location with a laser reading head (10).

3. The gripping method according to claim 1 or 2, **characterised in that** it comprises a final step of lowering the gripping head (14) and depositing the component (6) on a horizontal fitting (32).

4. The gripping method according to claim 3, **characterised in that** it effects the deposition of the component (6) on the fitting (32) with a lateral clearance (J) relative to a flange of this fitting (32).

5. The gripping method according to claim 4, **characterised in that**, after the component (6) has been placed on the fitting (32), it applies a lateral movement of this component (6) in order to bring it into contact with the lateral flange of the fitting (32) forming a position reference.

6. The gripping method according to any one of the preceding claims, **characterised in that** it activates an electromagnet forming the actuator, in order to raise or lower the stud (18).

7. A system for gripping magnetic components (6), **characterised in that** it comprises at least one moving gripping head (14), implementing a gripping method according to any one of the preceding claims.

8. The gripping system according to claim 7, **characterised in that** the gripping head (14) moves along a horizontal axis (X) and a vertical axis (Z).

9. The gripping system according to claim 7 or 8, **characterised in that** it comprises a rotating plate (30) comprising fittings (32) distributed around this plate (30), successively receiving the components (6).

10. The gripping system according to any one of claims 7 to 9, **characterised in that** it has a device for supplying the components which are placed on a continuous strip.
